**Europäisches Patentamt**

**European Patent Office**

**Office européen des brevets**

(19)

(11) Publication number : **0 453 201 B1**

(12)

# EUROPEAN PATENT SPECIFICATION

(45) Date of publication of patent specification :
**21.12.94 Bulletin 94/51**

(51) Int. Cl.⁵ : **H04B 3/06, H04L 25/03**

(21) Application number : **91303284.3**

(22) Date of filing : **12.04.91**

(54) **Control for adaptive equalizer.**

(30) Priority : **16.04.90 JP 100033/90**

(43) Date of publication of application :
**23.10.91 Bulletin 91/43**

(45) Publication of the grant of the patent :
**21.12.94 Bulletin 94/51**

(84) Designated Contracting States :
**BE CH DE ES FR GB IT LI NL**

(56) References cited :
**US-A- 3 781 720**
**US-A- 3 868 603**
**US-A- 3 992 616**
**PATENT ABSTRACTS OF JAPAN, unexamined applications, E field, Vol. 10, No. 289, October 2, 1986; & JP-A- 61 107 822**

(73) Proprietor : **MATSUSHITA ELECTRIC INDUSTRIAL CO., LTD.**
**1006, Oaza Kadoma**
**Kadoma-shi, Osaka-fu, 571 (JP)**

(72) Inventor : **Uesugi, Mitsuru**
**14-6, Kamoi-3-chome,**
**Midori-ku**
**Yokohama-shi, Kanagawa-ken 226 (JP)**

(74) Representative : **Smith, Norman Ian et al**
**F.J. CLEVELAND & COMPANY**
**40-43 Chancery Lane**
**London WC2A 1JQ (GB)**

EP 0 453 201 B1

## Description

The present invention relates to a control for an adaptive equalizer which is applied to a high transmission rate digital mobile communication system.

In particular, the present invention relates to a control for an equalizer disposed between an antenna for a receiver in a digital mobile communication system and a signal processing circuit (demodulator and the like) for outputting to the signal processing in unit an optimum signal (reference signal) of the inputted signals which have not been influenced by disturbances between a transmitter and the receiver since some of the signals transmitted from the transmitter are directly inputted to the receiver without being influenced while the other signals are reflected by buildings to cause fading or delayed by the reflection.

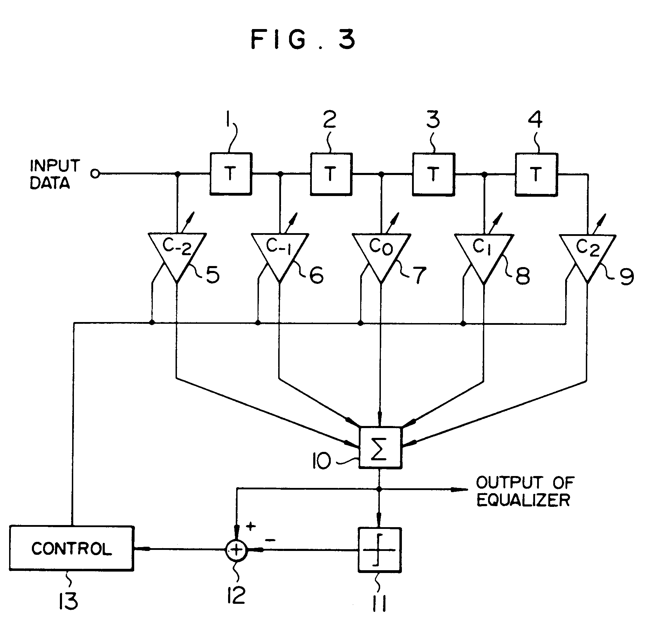

Fig. 3 shows a prior art control for an adaptive equalizer. A reference numeral 1 denotes a delay element for delaying an inputted data. Reference numerals 2 through 4 denote delay elements for delaying data from the delay elements 1 through 3 at the previous stage.

Reference numerals 5 through 9 denote amplifiers for weighting the input data to the delay element and the output data (tap output) from the delay elements 1 through 4, respectively. A reference numeral 10 denotes an adder for adding the outputs from the amplifiers 5 through 9. The delay elements 1 through 4, the amplifier 5 through 9 and the adder 10 form an equalizer.

Reference numerals 11 and 12 denote a discriminator for presuming the level of a reference signal from the output of the adder 10 and a subtracter for subtracting the level of the reference signal from the discriminator 11 from the level of the output of the adder 10, respectively.

In the above mentioned structure, the control 13 performs operation of the gains of all the amplifiers 5 through 9 by ZF or LMS method and updates the gains each time when the data are inputted to the delay elements 1 through 4 so that the inputted data are equalized.

Now, the ZF and LMS methods will be described. (1) The ZF (Zero Forcing) method is an algorism for controlling the weighting of the amplifiers 5 through 9 so that the errors are approximated to zero. Although this method is suitable for fast processing since the operation time is short, it has problems that there are conditions for convergence and that convergence speed is not fast. (2) LMS (Least Mean Square) method is an algorism for controlling the weighting of the amplifiers 5 through 9 so that the square of the errors become minimum. Operation is complicated and takes a long period of time while the convergence is always assured.

However, the LMS method has a problem in a pri-

or art control for an adaptive equalizer that this method cannot be used for high rate communication since operation speed is slow.

The ZF method has a difficulty in convergence and has a problem that the inputted data cannot be equalized particularly when it is used for the digital mobile communication in which the signals are generated in a burst manner.

Another prior art arrangement, similar to that described above, is described in US-A-3992616.

## SUMMARY OF THE INVENTION

The present invention was made for overcoming the above mentioned problems.

It is an object to provide a control for an adaptive equaliser which can enhance operation speed, convergence speed and convergence performance.

The invention is defined by the features of claim 1.

In the present invention, the gains of the amplifiers can be sequentially operated by the LMS method and updated each time when data are inputted to delay elements for overcoming the above mentioned problems.

Since the gains of the amplifiers are sequentially operated by the LMS method and updated each time when the data are inputted into the delay elements, operation of the gains of all the amplifiers are not performed each time when the data are inputted. Therefore, the present invention has advantages that the LMS method having a low operation speed can be used for high transmission rate communication and that the convergence speed is fast since the operation is performed by the LMS method.

The invention will be described now by way of example only with particular reference to the accompanying drawings. In the drawings:

Fig. 1 is a block diagram showing an embodiment of a control of an adaptive equalizer of the present invention;

Fig. 2A is a chart showing the output of an adder of the control of the qualizer;

Fig. 2B is a chart showing the output of a discriminator of the control; and

Fig. 3 is a block diagram showing a prior art control for an adaptive equalizer of the present invention.

## DESCRIPTION OF THE PREFERRED EMBODIMENTS

Embodiments of the present invention will be described with reference to the drawings.

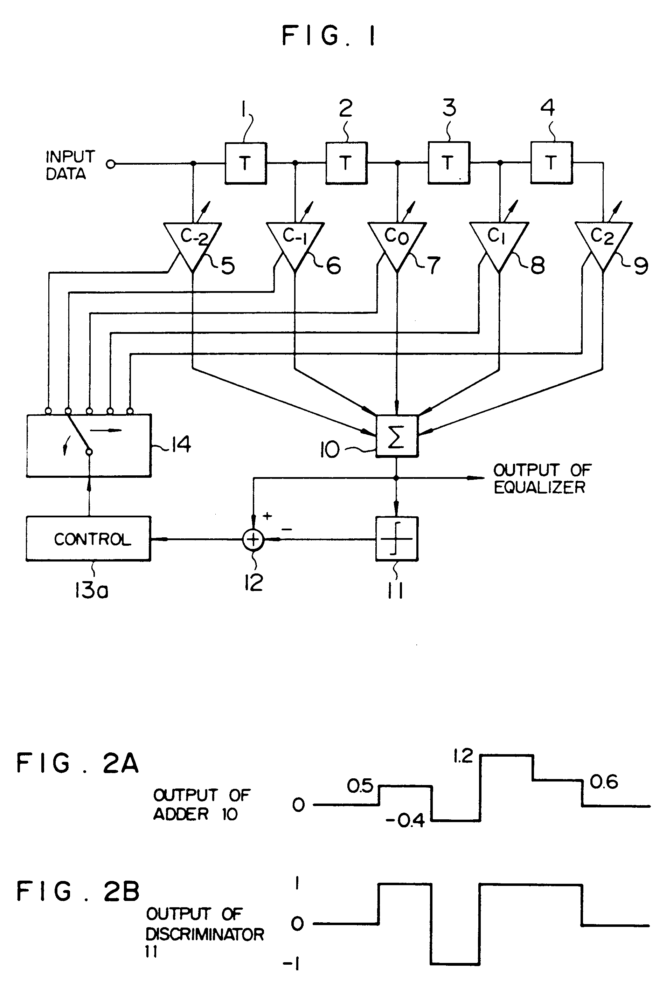

Fig. 1 is a block diagrams showing an embodiment of a control for an adaptive equalizer of the present invention in which components which are like to those in Fig. 3 are designated with like numerals.

In Fig. 1 a reference numeral 1 denotes a delay element for delaying an inputted data. Reference numerals 2 through 4 denote delay elements for delaying data from the delay elements 1 through 3 at the previous stage. Each delay element include a latch. Reference numerals 5 through 9 denote amplifiers for weighting the input data to the delay element and the output data (tap output) from the delay elements 1 through 4, respectively. A reference numeral 10 denotes an adder for adding the outputs from the amplifiers 5 through 9. The delay elements 1 through 4, the amplifier 5 through 9 and the adder 10 form an equalizer.

Reference numerals 11 and 12 denote a discriminator for presuming the level of a reference signal from the output of the adder 10 and a subtracter for subtracting the level of the reference signal from the discriminator 11 from the level of the output of the adder 10, respectively.

Reference numeral 13a denotes a control for sequentially operating each gain of the amplifiers 5 through 9 by the LMS method in predetermined order in accordance with the level of the signal from the subtracter 12 and a reference numeral 14 denotes a control order switching circuit which is switched by the control 13a for outputting the operated gain to the corresponding amplifier.

Now, operation of the thus formed embodiment will be described.

In Fig. 1, the inputted data are delayed by the serial delay elements 1 through 4 and are stored as a data train and then weighted by the amplifiers 5 through 9 in accordance with the following formula and then added by the adder 10 to provide an output signal to the equalizer.

$$C'y = Cy - \alpha \cdot \varepsilon \cdot Xy$$

wherein y = -2, -1, 0, 1, 2 for the amplifiers 5, 6, 7, 8, 9, respectively;

Cy denotes the gain of the amplifier at time $t = t_n$;

C'y denotes the gain of the amplifier at time $t = t_{n+1}$;

Xy denotes an input signal at time $t = t_n$;

$\varepsilon$ denotes the difference between the outputs of the adder 10 and the discriminator 11 at time $t = t_n$;

$\alpha$ denotes a constant =

$$\frac{1}{\text{the number of taps (5 in the embodiment)}} \times (\frac{1}{4} \sim \frac{1}{8})$$

which is same for all amplifiers.

The discriminator 11 presumes the level of the reference signal in accordance with an output signal of the equalizer (adder 10) as shown in Fig. 2A and outputs the output signal -1, 0, +1 as shown in Fig. 2B. The subtracter 12 subtracts the level of the reference signal from the discriminator 11 from the level of the output signal of the equalizer 10 to output a signal to the control 13a.

The control 13a operates the gain of one of the amplifiers 5 through 9 in predetermined order and switches the control order switching device 14 for updating the gain of the amplifier in interest to the operated gain.

When another inputted data is inputted into the delay element 1, the data stored in the delay elements 1 through 4 are sequentially shifted to the subsequent delay elements 2 through 4 and the amplifier 9 and weighted by the amplifiers 5 through 9. The weighted signals are added by the adder 10. The discriminator 11 presumes the reference signal level in accordance with the output signal of the equalizer and outputs an output signal representative of the reference signal level. The subtracter 12 subtracts the reference signal level determined by the discriminator 11 from the output signal level of the equalizer to output a signal representative of the difference to the control 13a.

The control 13a operates the gain of next one of the amplifiers 5 through 9 in predetermined order and switches the control order switcher 14 for updating the gain of the amplifier in interest to the operated gain.

Accordingly, the control 13a consecutively operates the gain of one of the amplifiers 5 through 9 in predetermined order in accordance with the present embodiment each time when a data is inputted. Therefore, the gain can be updated within an operation period of time which is 1/5 of that required in the prior art in which there are provided five amplifiers 5 through 9.

The control 13a has an advantage that the convergence is fast since the control performs the operation by the LMS method.

Since the multi-path fading which is the largest obstacle of the digital mobile communication system has less fluctuations with time, it is not serious even if the gain of one of the amplifiers 5 through 9 is sequentially operated and compensated for each time when the data is inputted. The advantage of the LMS method is not lost.

Although the gain of one amplifier is operated at one time, in the present embodiment, the gains of a plurality of amplifiers may be operated at the same time and the amplifiers, the gains of which are to be operated may be sequentially changed at given times.

## Claims

1. A control apparatus for an adaptive equalizer including:

   a plurality of delay elements (1 to 4) connected in series to each other for delaying input data applied to a first stage of said delay elements;

   a plurality of amplifiers (5 to 9) each connected to a tap of each of said delay elements for weighting the delayed data of said delay elements;

an adder (10) connected to said amplifiers for adding output signals of said amplifiers to each other;

a discriminator (11) connected to said adder for producing a reference signal in accordance with an output signal of said adder; and

control means (13a) connected to said discriminator for sequentially calculating a gain for each of the amplifiers on the basis of a difference between the output signal of said adder and the reference signal produced by said discriminator, said apparatus being characterised by comprising:

control order switching means (14) connected to said control means (13a) for selectively applying the gain calculated by said control means (13a) to one of the amplifiers each time that data is input into said delay elements (1 to 4), whereby each one of the amplifiers is selected in a predetermined order and whereby the step of applying said calculated gain is performed for each amplifier in turn.

2. A control apparatus for an adaptive equaliser according to claim 1, characterised in that the gains of the amplifiers (5 to 9) are operated by the least mean square method.

3. A control apparatus for an adaptive equaliser according to claim 1 or claim 2, characterised in that each of the delay elements (1 to 4) comprises a latch.

**Patentansprüche**

1. Steuervorrichtung für einen adaptiven Entzerrer mit:

einer Anzahl miteinander in Reihe geschalteter Verzögerungselemente (1 bis 4) zum Verzögern an einer ersten Stufe der Verzögerungselemente anliegender Eingangsdaten;

einer Anzahl jeweils mit einem Abgriff an jeweils einem der Verzögerungselemente verbundener Verstärker (5 bis 9) zum Gewichten der von den Verzögerungselementen verzögerten Daten;

einem mit den Verstärkern verbundenen Addierer (10) zum miteinander Addieren von Ausgangssignalen der Verstärker;

einem mit dem Addierer verbundenen Diskriminator (11) zum Erzeugen eines Referenzsignals entsprechend einem Ausgangssignal des Addierers; und

einer mit dem Diskriminator verbundenen Steuereinrichtung (13a) zum sequentiellen Berechnen einer Verstärkung für jeden der Verstärker auf der Basis einer Differenz zwischen dem Ausgangssignal des Addierers und dem von dem Diskriminator erzeugten Referenzsignal, wobei die Vorrichtung *dadurch gekennzeichnet ist,* daß sie umfaßt:

eine mit der Steuereinrichtung (13a) verbundene Steuerreihenfolgenumschalteinrichtung (14) zum selektiven Anlegen der von der Steuereinrichtung (13a) berechneten Verstärkung an einen der Verstärker, jedesmal wenn Daten an die Verzögerungselemente (1 bis 4) gehen, wodurch jeder der Verstärker nach einer vorbestimmten Reihenfolge angewählt wird und wodurch der Schritt des Anlegens der berechneten Verstärkung für jeden einzelnen Verstärker der Reihe nach ausgeführt wird.

2. Steuervorrichtung für einen adaptiven Entzerrer nach Anspruch 1, *dadurch gekennzeichnet, daß* die Verstärkungen der Verstärker (5 bis 9) nach dem Verfahren der kleinsten Fehlerquadrate gesteuert werden.

3. Steuervorrichtung für einen adaptiven Entzerrer nach Anspruch 1 oder 2, *dadurch gekennzeichnet, daß* jedes der Verzögerungselemente (1 bis 4) einen Zwischenspeicher aufweist.

**Revendications**

1. Appareil de commande pour égaliseur adaptatif comprenant :

plusieurs éléments à retard (1 à 4) connectés les uns aux autres en série pour retarder des données d'entrée appliquées à un premier étage desdits éléments à retard ;

plusieurs amplificateurs (5 à 9), chacun d'eux étant connecté à une prise desdits éléments à retard pour pondérer les données retardées desdits éléments à retard;

un additionneur (10) connecté auxdits amplificateurs pour additionner les signaux de sortie desdits amplificateurs les uns aux autres;

un discriminateur (11) connecté audit additionneur pour émettre un signal de référence en fonction d'un signal de sortie dudit additionneur ; et

un moyen de commande (13a) connecté audit discriminateur pour effectuer de manière séquentielle le calcul d'un gain pour chacun des amplificateurs sur la base d'une différence entre le signal de sortie dudit additionneur et le signal de référence émis par ledit discriminateur, ledit appareil étant caractérisé en ce qu'il comprend :

un moyen de commutation d'ordre de commande (14) connecté audit moyen de commande (13a) pour appliquer de façon sélective le gain calculé par ledit moyen de commande (13a) à l'un des amplificateurs à chaque fois qu'une donnée est introduite dans lesdits éléments à retard (1 à 4), chacun des amplificateurs étant sélectionné selon un ordre prédéterminé et l'étape d'application du gain calculé étant effectuée pour chaque amplificateur tour à tour.

2. Appareil de commande pour égaliseur adaptatif selon la revendication 1, caractérisé en ce que les gains des amplificateurs (5 à 9) sont calculés selon la méthode du plus petit carré moyen.

3. Appareil de commande pour égaliseur adaptatif selon la revendication 1 ou 2, caractérisé en ce que chaque élément à retard (1 à 4) comprend un verrou.

# FIG. 1

INPUT DATA

1  2  3  4

T  T  T  T

$C_{-2}$  $C_{-1}$  $C_0$  $C_1$  $C_2$

5  6  7  8  9

14

$\Sigma$

10

OUTPUT OF EQUALIZER

CONTROL

13a

+  −

12

11

# FIG. 2A

OUTPUT OF ADDER 10

0    0.5    1.2    0.6
     −0.4

# FIG. 2B

OUTPUT OF DISCRIMINATOR 11

1
0
−1

# FIG. 3